# EUROPÄISCHE PATENTSCHRIFT

(11) **EP 0 883 899 B1**
(45) Veröffentlichungstag und Bekanntmachung des Hinweises auf die Patenterteilung: **17.09.2003**
(21) Anmeldenummer: 97914163.7
(22) Anmeldetag: 28.02.1997
(51) Int. Cl.: H01L 21/66

(54) **VERFAHREN ZUM BESTIMMEN DER KRISTALLORIENTIERUNG IN EINEM WAFER**
PROCESS FOR DETERMINING THE CRYSTAL ORIENTATION IN A WAFER
PROCEDE POUR DETERMINER L'ORIENTATION DE CRISTAUX DANS UNE PLAQUETTE

(30) Priorität: 01.03.1996 DE 19609399
(43) Veröffentlichungstag der Anmeldung: 16.12.1998
(73) Patentinhaber: SIEMENS AKTIENGESELLSCHAFT, 80333 München (DE)
(72) Erfinder: WINKLER geb. JANTKE, Gabriele, 13587 Berlin (DE); STECKENBORN, Arno, 13589 Berlin (DE); WINKLER, Thoralf, 01665 Gauernitz (DE)
(86) Internationale Anmeldenummer: DE9700440
(87) Internationale Veröffentlichungsnummer: WO97032341

(56) Entgegenhaltungen:
- DE-A- 4 136 089
- PATENT ABSTRACTS OF JAPAN vol. 014, no. 541 (E-1007), 29.November 1990 & JP 02 230751 A (HITACHI LTD), 13.September 1990,

## Beschreibung

Die Erfindung bezieht sich auf ein Verfahren zum Bestimmen der Kristallorientierung in einem Wafer aus einem Kristall mit einer Zinkblende-Kristallstruktur, bei dem eine wie Kreisskalenstriche nebeneinander angeordnete Maskenöffnungen aufweisende Ätzmaske, die einen bestimmten Radius aufweist, in bezug auf eine vorgegebene Markierung des Wafers aufgebracht wird, und der Wafer anisotrop unter Gewinnung ausgeätzter Rinnen geätzt wird, wobei aus der Ätzstruktur der Rinnen auf die Kristallorientierung geschlossen wird. Eine Zinkblende-Kristallstruktur weist beispielsweise Silizium oder Germanium oder Gallium-Arsenid auf.

Ein derartiges Verfahren ist aus der Veröffentlichung "A latching accelerometer fabricated by the anisotropic etching of (110)-oriented silicon wafers" von Dino R. Ciarlo in der Zeitschrift "Micromech. Microeng.", 2, 1992, Seiten 10 bis 13, bekannt. Bei dem bekannten Verfahren sind rechteckige Maskenöffnungen wie Kreisskalenstriche nebeneinander angeordnet. Der Winkel zwischen zwei aufeinanderfolgenden rechteckigen Maskenöffnungen beträgt 0,1°. Die rechteckigen Maskenöffnungen sind jeweils 8 um breit und 3 mm lang. Beim anisotropen Ätzen der mit der Ätzmaske versehenen Waferoberfläche entstehen an den Seiten der Maskenöffnungen unterätzte Zonen, die von (111)-Ebenen begrenzt werden. Je nach Orientierung der Maskenöffnung relativ zur gesuchten Kristallorientierung ist die Dimension der unterätzten Zone unterschiedlich. Die Dimension der jeweiligen unterätzten Zonen wird optisch ermittelt, und die Lage der Maskenöffnung, an deren Seite die unterätzte Zone am kleinsten ist, wird zur Feststellung der Kristallorientierung herangezogen. Die Dimension der kleinsten unterätzten Zone muß größer als die Wellenlänge des zum Messen benutzten Lichtes sein, um wahrgenommen werden zu können, d.h. sie muß größer als etwa 0,5 µm sein. Dies wird bei dem bekannten Verfahren unter anderem durch die gewählten Maße der rechteckigen Maskenöffnungen gewährleistet. Die erreichbare Winkelgenauigkeit bei der Feststellung der Kristallorientierung mit dem bekannten Verfahren ist durch den Winkel zwischen zwei jeweils nebeneinander angeordneten Maskenöffnungen bedingt. Dieser Winkel kann aus Maskenherstellungsgründen nicht kleiner als 0,1° gemacht werden. Die beste erreichbare Genauigkeit bei der Bestimmung der Kristallorientierung ist also 0,05°. Die erforderliche Ätzzeit bei dem bekannten Verfahren beträgt, bedingt durch die Länge der rechteckigen Maskenöffnungen, etwa 30 Stunden. Eine Reduzierung der Länge der rechteckigen Maskenöffnungen hätte zwar eine Verkürzung der Ätzzeit zur Folge, würde sich aber auch auf die Dimension der unterätzten Zonen in der Weise auswirken, daß diese Zonen optisch nicht mehr meßbar wären.

Der Erfindung liegt die Aufgabe zugrunde, ein Verfahren zur Bestimmung der Kristallorientierung in einem Wafer vorzuschlagen, bei dem mit einem vergleichsweise geringen Zeitaufwand mindestens die gleiche Genauigkeit bei der Bestimmung der Kristallorientierung wie bei dem bekannten Verfahren erzielbar ist.

Die Lösung der gestellten Aufgabe wird durch ein Verfahren gemäß Anspruch 1 erzielt.

Ein Vorteil des erfindungsgemäßen Verfahrens besteht darin, daß die Länge der doppel-T-artigen Maskenöffnungen um mindestens eine Größenordnung kleiner als die Länge der rechteckigen Maskenöffnungen bei dem bekannten Verfahren gewählt werden kann und somit die erforderliche Ätzzeit entsprechend reduziert wird. Dabei bewirkt die Verwendung der doppel-T-artigen Maskenöffnungen, daß die Dimension der unterätzten Zonen optisch gut meßbar bleibt. Die Genauigkeit bei der Bestimmung der Kristallorientierung ist mindestens so gut wie bei dem bekannten Verfahren.

Bei einer vorteilhaften Ausgestaltung des erfindungsgemäßen Verfahrens wird der Wafer solange geätzt, bis nur ein Zwischenraum erhalten bleibt. Ein Vorteil bei dieser Vorgehensweise ist darin zu sehen, daß zur Bestimmung der Lage des Zwischenraumes nur ein relativ geringer Meßaufwand betrieben werden muß. Beispielsweise ist es möglich, die Lage dieses Zwischenraumes mit dem bloßen Auge zu bestimmen.

Eine weitere vorteilhafte Ausgestaltung des erfindungsgemäßen Verfahrens wird erreicht, indem der Wafer solange geätzt wird, bis sich jeweils eine vom ersten Segment oder vom zweiten Segment der Maskenöffnungen entlang des Bereiches ausbildende Ätzfront über mehr als die halbe Länge des Bereiches erstreckt, und die Größen aller nicht unteräzten Zwischenräume zwischen jeweils zwei Maskenöffnungen werden zur Feststellung der Kristallorientierung herangezogen.

Ein Vorteil bei dieser weiteren Ausgestaltung des erfindungsgemäßen Verfahrens ist, daß anhand der Vielzahl von ermittelten Größen der Zwischenräume die Kristallorientierung mit einer relativ großen Genauigkeit festgestellt werden kann.

Eine zusätzliche vorteilhafte Ausgestaltung des erfindungsgemäßen Verfahrens wird erreicht, indem aus optischen Messungen von längs einer parallel zu den Segmenten verlaufenden und den Bereich etwa in seiner Mitte schneidenden Orientierungsgerade von dem Wafer reflektierten Intensitäten eine Reihe von Lichtintensitätswerten gewonnen wird, und
die Reihe von Intensitätswerten zur Berechnung der in Richtung der Orientierungsgeraden verbleibenden Größen der nicht unterätzten Zwischenräume zwischen jeweils zwei nebeneinander angeordneten Maskenöffnungen herangezogen wird.

Ein Vorteil dieser zusätzlichen Ausgestaltung des erfindungsgemäßen Verfahrens liegt darin, daß die genaue Feststellung der Kristallorientierung maschinell durchgeführt werden kann, d. h. sie kann in einer automatisierten Produktionseinheit eingesetzt werden.

In einer weiteren Ausgestaltung des erfindungsgemäßen Verfahrens wird bei einem kreisförmigen Wafer als vorgegebene Markierung eine parallel zu einem Flat des Wafers verlaufende Radiuslinie gewählt, der Abstand einer dieser beiden Maskenöffnungen von der Radiuslinie bestimmt und
die Kristallorientierung wird durch Bestimmen des Winkels über einer Tangensfunktion aus der Radiuslinie und dem Abstand ermittelt.

Ein Vorteil dieser weiteren Ausgestaltung des erfindungsgemäßen Verfahrens ist darin zu sehen, daß der Wafer nach Ermittlung des Winkels durch entsprechendes Drehen leicht in Richtung der Kristallorientierung positioniert werden kann.

Zur Erläuterung des erfindungsgemäßen Verfahrens ist in
Figur 1 ein Wafer mit einer zur Durchführung des erfindungsgemäßen Verfahrens geeigneten Maske, in
Figur 2 ein vergrößerter Ausschnitt aus dem mit der Maske bedeckten Bereich des Wafers, in
Figur 3 ein Ätzergebnis bei der Anwendung des erfindungsgemäßen Verfahrens bei demselben Ausschnitt, in
in Figur 4 ein Querschnitt durch eine mit einer Ätzmaske versehene geätzte Zinblende-Kristallstruktur an der Stelle einer Maskenöffnung und in
Figur 5 eine Kurve reflektierter Lichtintensitäten an der Stelle derselben Maskenöffnung dargestellt.

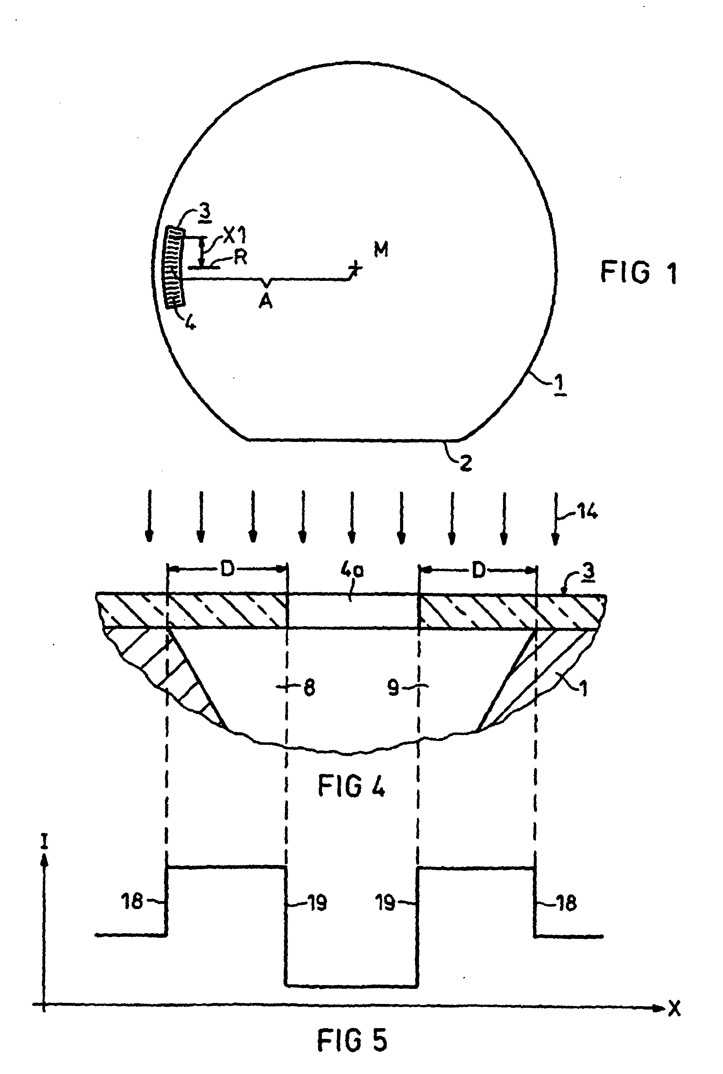

In der Figur 1 ist ein kreisförmiger Wafer 1 dargestellt, der in Form eines sogenannten Flat eine vorgegebene Markierung 2 aufweist. Die Markierung 2 ist vom Hersteller des Wafers 1 mit einer Genauigkeit von ±0,5° zur Kristallorientierung angebracht. Diese Genauigkeit ist für viele Fälle der Weiterbearbeitung eines Wafers nicht ausreichend, weshalb beispielsweise vor einer Aufbringung von Masken zur ätzenden Bearbeitung des Wafers eine bessere Ausrichtung des Wafers im Hinblick auf seine Kristallorientierung erforderlich ist.

Liegt beispielsweise die Oberfläche des Wafers 1 in der (100)-Ebene, dann kann es erforderlich sein, die (110)-Richtung möglichst genau zu bestimmen. Zu diesem Zweck ist auf den Wafer 1 eine kreisringförmige Ätzmaske 3 aufgebracht, von der in der Figur 1 nur einige Maskenöffnungen 4 schematisch durch Striche dargestellt sind. Die Maske 3 ist in einem mittleren Abstand A vom Mittelpunkt M des kreisförmigen Wafers 1 aufgebracht. Außerdem ist auf den Wafer 1 ein Stück R einer Radiuslinie markiert, die parallel zu der vorgegebenen Markierung 2 ausgerichtet ist.

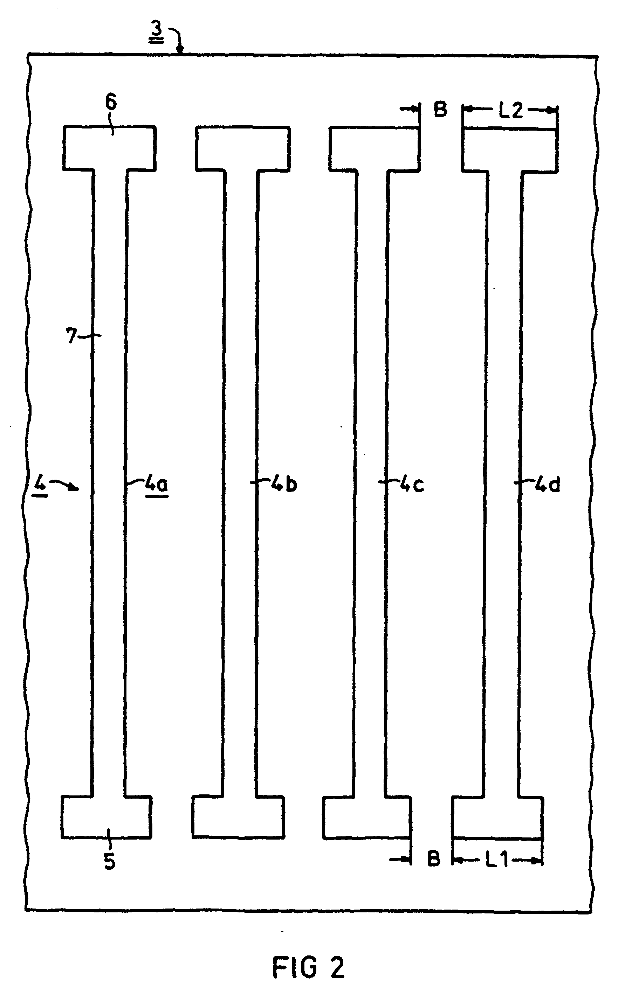

Wie Figur 2 im einzelnen erkennen läßt, weist der dort dargestellte Maskenausschnitt doppel-T-artige Maskenöffnungen 4a, 4b, 4c und 4d auf, die jeweils aus einem ersten Segment 5 und einem zweiten Segment 6 bestehen, wobei das erste Segment 5 mit einer Länge L1 etwas kürzer als das zweite Segment 6 mit einer Länge L2 ist; zwischen den Segmenten 5 und 6 jeder der Maskenöffnungen 4a bis 4d liegt ein Bereich 7. Die doppel-T-artigen Maskenöffnungen 4a bis 4d sind in einer Weise nebeneinander angeordnet, daß die ersten Segmente 5 und die zweiten Segmente 6 jeweils in einem vorbestimmten Abstand B voneinander und insgesamt ihrer Längsrichtung nach näherungsweise in der (110)-Richtung liegen. Dabei sind die Bereiche 7 der Maskenöffnungen in gleichbleibenden Abständen voneinander angeordnet.

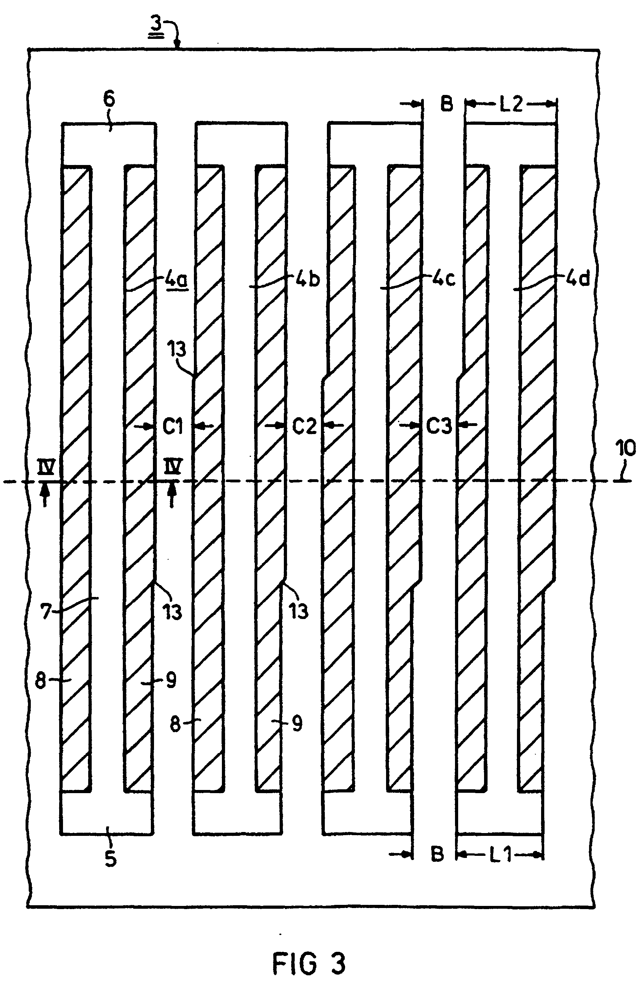

Nach dem Auftragen der Ätzmaske 3 erfolgt ein anisotropes Ätzen. Dabei bilden sich unter die Ätzmaske 3 reichende, unterätzte Zonen 8 und 9 (schräg schraffiert) zwischen jeweils zwei zu einer Maskenöffnung zugehörigen Segmenten 5 und 6, wie Figur 3 erkennen läßt. Bedingt durch die anisotropen Ätzeigenschaften der Zinkblende-Kristallstruktur werden die Zonen 8 und 9 von (111)-Ebenen begrenzt, die die Waferoberfläche in (110)-Richtung schneiden. Längs einer Geraden 10 sich ergebende Breitenabmessungen C1, C2 und C3 nicht unterätzter Zwischenräume zwischen äußeren Rändern von unterätzten Zonen 8 und 9 jeweils benachbarter Maskenöffnungen 4a, 4b und 4b, 4c sowie 4c, 4d werden um so kleiner, je weiter die jeweilige Maskenöffnung von der Maskenöffnung entfernt liegt, die recht genau entsprechend der (110)-Richtung liegt. Mit anderen Worten, es kann die Lage der Maskenöffnung 4a, an deren Seite die Breite C1 des nicht unterätzten Zwischenraumes am größten ist, zur Feststellung der Kristallorientierung herangezogen werden.

Die (111)-Ebenen wirken bei dem dargestellten Ausführungsbeispiel begrenzend auf den Atzprozeß, weil sie im Vergleich zu den (110)- und (100)-Ebenen nur mit einer Geschwindigkeit, die im Verhältnis etwa 600:300:1 für die (110):(100):(111)-Ebenen liegt, weggeätzt werden. Das bedeutet, daß der Ätzprozeß solange fortgesetzt werden kann, bis die Breitenabmessungen C2 und C3 zu Null werden und nur noch eine Breitenabmessung C1 verbleibt. Die Lage des zur verbleibenden Breiteabmessung C1 gehörigen Zwischenraumes wird dann zur Bestimmung der Kristallorientierung herangezogen.

Anderseits kann der Ätzprozeß auch unterbrochen werden, nachdem sich entlang des Bereiches 7 ausbildende Ätzfronten 13 über die Gerade 10 hinaus erstreckt haben. Die Abmessungen der unterätzten Zonen 8 und 9 können längs der Gerade 10 beispielsweise ermittelt werden, indem die Ätzmaske 3 mit Licht bestrahlt wird und Intensitätswerte längs der Gerade 10 reflektierten Lichts zur Bildung einer Lichtintensitätskurve gewonnen werden.

Im einzelnen kann dabei so vorgegangen werden, daß - wie Figur 4 zeigt, in der sehr stark vergrößert der Bereich um die Maskenöffnung 4a dargestellt ist - ein paralleles Bündel beispielsweise weißen Lichts 14 auf die Ätzmaske 4 eingestrahlt wird. Die Maskenöffnung 4a reflektiert das einfallende Licht am wenigsten, während der die unterätzten Zonen überragende Teil der Ätzmaske 3 das Licht am stärksten reflektiert. Interessant ist die Abmessung D der unterätzten Zonen 8 und 9, weil aus den ermittelten Abmessungen D der unterätzten Zonen 8 und 9 die Breitenabmessungen C1, C2 und C3 der nicht unterätzten Zwischenräume berechnet werden können.

Aus Flanken 18 und 19 der in Figur 5 dargestellten Kurve der Lichtintensität über die Breite X der Maske 3 kann die Abmessung D meßtechnisch ermittelt werden.

Sind über die Bestimmung der Breitenabmessungen der unterätzten Zwischenräume zwischen den Maskenöffnungen 4a bis 4d die beiden Maskenöffnungen (z.B. 4a und 4b gemäß Fig. 3) bestimmt, zwischen denen der Zwischenraum am wenigsten unterätzt ist, dann wird ihr Abstand X1 von dem Teil R der Radiuslinie bestimmt. Aus diesem ermittelten Abstand X1 und dem Abstand A der Ätzmaske 3 vom Mittelpunkt M läßt sich dann über die Tangensfunktion der Winkel bestimmen, um den der Wafer 1 ausgehend vom Flat 2 gedreht werden muß, um eine zur Bearbeitung des Wafers aufzubringende Ätzmaske exakt zur Kristallorientierung ausgerichtet plazieren zu können.

Bei Verwendung von doppel-T-artigen Maskenöffnungen 4a bis 4d mit einer Gesamtlänge von etwa 200 µm kann eine Genauigkeit von mindestens 0,01° bei der Bestimmung der Kristallorientierung erreicht werden, wobei die Ätzzeit geringer als 2 Stunden ist.

## Patentansprüche

1. Verfahren zum Bestimmen der Kristallorientierung in einem Wafer aus einem Kristall mit einer Zinkblende-Kristallstruktur, bei dem
- eine wie Kreisskalenstriche nebeneinander angeordnete Maskenöffnungen aufweisende Ätzmaske, die einen bestimmten Radius aufweist, in bezug auf eine vorgegebene Grobmarkierung der Kristallorientierung des Wafers aufgebracht wird,
- der Wafer anisotrop unter Gewinnung ausgeätzter Rinnen geätzt wird, wobei aus der Ätzstruktur der Rinnen auf die Kristallorientierung geschlossen wird, und
- die Kristallorientierung mit hilfe der Lage in bezug auf die vorgegebene Markierung einer derjenigen benachbarten Maskenöffnungen (4a;4b), zwischen denen der Zwischenraum am wenigsten unterätzt ist, bestimmt wird,
**dadurch gekennzeichnet, daß**
- die Maskenöffnungen (4a bis 4d) jeweils zwei in ihrer Längsrichtung parallel zueinander ausgerichtete Segmente (5,6) enthalten, wobei das jeweils erste Segment (5) etwas kürzer als das jeweils zweite Segment (6) ist, und jeweils einen im Vergleich zu den ersten und zweiten Segmenten relativ lang bemessenen Bereich (7) aufweisen, der sich zwischen dem jeweiligen ersten und zweiten Segment (5,6) erstreckt, wodurch eine doppel-T-artige Maskenöffnung (4a bis 4d) gebildet wird,
- die Maskenöffnungen (4a bis 4d) in der Weise nebeneinander angeordnet werden, daß bei gleich großen Abständen der Bereiche (7) die ersten Segmente (5) und die zweiten Segmente (6) in einem vorbestimmten, gleichen Abstand (B) voneinander liegen.

2. Verfahren nach Anspruch 1,
**dadurch gekennzeichnet, daß**
- der Wafer solange geätzt wird, bis nur ein Zwischenraum erhalten bleibt.

3. Verfahren nach Anspruch 1,
**dadurch gekennzeichnet, daß**
- der Wafer (1) solange geätzt wird, bis sich jeweils eine vom ersten Segment (5) oder vom zweiten Segment (6) der Maskenöffnungen (4a bis 4d) entlang des Bereiches (7) ausbildende Ätzfront über mehr als die halbe Länge des Bereiches (7) erstreckt, und
- die Größen (C1,C2,C3) aller nicht unteräzten Zwischenräume zwischen jeweils zwei Maskenöffnungen zur Feststellung der Kristallorientierung herangezogen werden.

4. Verfahren nach Anspruch 3,
**dadurch gekennzeichnet, daß**
- aus optischen Messungen von längs einer parallel zu den Segmenten (5,6) verlaufenden und den Bereich (7) etwa in seiner Mitte schneidenden Orientierungsgerade (10) von dem Wafer (1) reflektierten Lichtintensitäten eine Reihe von Intensitätswerten gewonnen wird,
- die Reihe von Intensitätswerten zur Berechnung der in Richtung der Orientierungsgeraden (10) verbleibenden Größen der nicht unterätzten Zwischenräume zwischen jeweils zwei nebeneinander angeordneten Maskenöffnungen herangezogen wird.

5. Verfahren nach einem der vorangehenden Ansprüchen,
**dadurch gekennzeichnet, daß**
- bei einem kreisförmigen Wafer (1) als vorgegebene Markierung eine parallel zu einem Flat (2) des Wafers (1) verlaufende Radiuslinie gewählt wird,
- der Abstand (X1) einer dieser beiden Maskenöffnungen (4a; 4b) von der Radiuslinie (R) bestimmt wird, und
- die Kristallorientierung durch Bestimmen des Winkels über eine Tangensfunktion aus der Radiuslinie (R) und dem Abstand (X1) ermittelt wird.

## Claims

1. Process for determining the crystal orientation in a wafer made of a crystal with a zinc blende crystal structure, in which
- an etching mask which has mask openings arranged next to one another like circular scale marks and has a specific radius is applied with regard to a predetermined coarse marking of the crystal orientation of the wafer,
- the wafer is etched anisotropically to obtain etched-out channels, the crystal orientation being inferred from the etching structure of the channels, and
- the crystal orientation is determined with the aid of the position with regard to the predetermined marking of one of those adjacent mask openings (4a; 4b) between which the interspace is undercut the least,
**characterized in that**
- the mask openings (4a to 4d) each contain two segments (5, 6) oriented parallel to one another in their longitudinal direction, the respective first segment (5) being somewhat shorter than the respective second segment (6), and each have a region (7) which is dimensioned to be relatively long in comparison with the first and second segments and extends between the respective first and second segments (5, 6), thereby forming a double-T-like mask opening (4a to 4d),
- the mask openings (4a to 4d) are arranged next to one another in such a way that, given identical distances between the regions (7), the first segments (5) and the second segments (6) lie at a predetermined, identical distance (B) from one another.

2. Process according to Claim 1,
**characterized in that**
- the wafer is etched until only one interspace is preserved.

3. Process according to Claim 1,
**characterized in that**
- the wafer (1) is etched until in each case an etching front forming from the first segment (5) or from the second segment (6) of the mask openings (4a to 4d) along the region (7) extends over more than half the length of the region (7), and
- the sizes (C1, C2, C3) of all the interspaces that are not undercut between in each case two mask openings are used for ascertaining the crystal orientation.

4. Process according to Claim 3,
**characterized in that**
- a series of intensity values is obtained from optical measurements of light intensities reflected from the wafer (1) along an orientation straight line (10) which runs parallel to the segments (5, 6) and intersects the region (7) approximately in its centre,
- the series of intensity values is used to calculate the sizes of the interspaces that are not undercut between in each case two mask openings arranged next to one another, the said sizes remaining in the direction of the orientation straight line (10).

5. Process according to one of the preceding claims,
**characterized in that**
- in the case of a circular wafer (1), a radius line running parallel to a flat (2) of the wafer (1) is chosen as predetermined marking,
- the distance (X1) between one of these two mask openings (4a; 4b) and the radius line (R) is determined, and
- the crystal orientation is determined by determining the angle by means of a tangent function from the radius line (R) and the distance (X1).

## Revendications

1. Procédé de détermination de l'orientation de cristaux dans une tranche en un cristal ayant la structure cristalline de la blende de zinc, dans lequel
- on dépose un masque d'attaque qui a des ouvertures de masque disposées côte à côte comme des traits de quadrant circulaire et qui a un rayon déterminé par rapport à un repérage grossier de l'orientation cristalline donnée à l'avance de la tranche,
- on attaque la tranche d'une manière anisotrope en produisant des rainures obtenues par attaque en tirant des conclusions sur l'orientation cristalline de la structure d'attaque des rainures et on détermine l'orientation cristalline à l'aide de la position par rapport au repérage donné à l'avance de l'une des ouvertures (4a, 4b) voisines du masque entre lesquelles l'intervalle est au moins en partie attaqué latéralement,
**caractérisé en ce que**
- les ouvertures (4a à 4d) de masque ont respectivement deux segments (5, 6) dirigés parallèlement l'un à l'autre dans leur direction longitudinale, le premier segment (5) étant un peu plus court que le second segment (6) et elles ont respectivement une partie (7) relativement longue par rapport au premier et au second segment, qui s'étend entre le premier et le second segment (5, 6) respectif en formant ainsi une ouverture (4a à 4d) de masque en forme de double T,
- on dispose les ouvertures (4a à 4b) de masque côte à côte de façon à ce que, pour des intervalles de même dimension entre les parties (7), les premiers segments (5) et les seconds segments (6) se trouvent à une même distance (B) l'un de l'autre déterminée à l'avance.

2. Procédé suivant la revendication 1,
**caractérisé en ce que**
- on attaque la tranche jusqu'à ce qu'il ne reste qu'un intervalle.

3. Procédé suivant la revendication 1,
**caractérisé en ce que**
- on attaque la tranche (1) jusqu'à ce que respectivement un front d'attaque se formant du premier segment (5) ou du second segment (6) des ouvertures (4a à 4d) de masqué le long de la partie (7) s'étende sur plus de la moitié de la longueur de la partie (7) et
- on tire parti des dimensions (C1, C2, C3) de tous les intervalles qui n'ont pas subi d'attaque latérale et qui se trouvent respectivement entre deux ouvertures de masque pour constater l'orientation des cristaux.

4. Procédé suivant la revendication 3,
**caractérisé en ce que**
- à partir de mesures optiques d'intensités lumineuses réfléchies par la tranche (1) le long de droites (10) d'orientation s'étendant parallèlement aux segments (5, 6) et coupant la partie (7) à peu près en son milieu, on obtient une série de valeurs d'intensité,
- on tire parti de la série de valeurs d'intensité pour calculer les dimensions restantes dans la direction des droites (10) d'orientation des intervalles qui n'ont pas subi une attaque latérale et qui sont compris entre respectivement deux ouvertures de masque disposées côte à côte.

5. Procédé suivant l'une des revendications précédentes,
**caractérisé en ce que**
- pour une tranche (1) de forme circulaire, on choisit comme repérage donné à l'avance une ligne de rayon s'étendant parallèlement à un méplat (2) de la tranche (1),
- on détermine la distance (X1) de l'une de ces deux ouvertures (4a; 4b) de masque à la ligne (R) de rayon et
- on détermine l'orientation des cristaux en déterminant l'angle par une fonction tangente à partir de la ligne (R) de rayon et de la distance (X1).
